# EUROPEAN PATENT APPLICATION

(11) **EP 4 240 121 A1**
(43) Date of publication of application: **06.09.2023**
(21) Application number: 22159461.7
(22) Date of filing: 01.03.2022
(51) Int. Cl.: H05K 3/32, H05K 1/18

(54) **METHOD FOR CONNECTING A FLEXIBLE PRINTED CIRCUIT TO A BUSBAR AND AN ARRANGEMENT OF A BUSBAR AND A METAL SHEET**

(71) Applicant: Rogers BV, 9940 Evergem (BE)
(72) Inventor: Zhou, Wei, Suzhou (CN); Hu, Xiaobo, Suzhou (CN); Shi, Wei, Suzhou (CN); De Boodt, Sebastian, Evergem (BE)
(74) Representative: Müller Schupfner & Partner Patent- und Rechtsanwaltspartnerschaft mbB

(57) **Abstract**

A method for connecting a flexible printed circuit to a busbar (1), comprising
- providing a metal sheet (2) having a thickness between 0.1 mm and 0.5 mm, preferably between 0.13 and 0.3 and more preferably between 0.15 and 0.25 mm, wherein the metal sheet (2) is connected to the flexible printed circuit (FPC), and providing the busbar (1),
- arranging the metal sheet (2) at least partially on the busbar (1) for forming a contact region (CR),
- welding the metal sheet (2) to the busbar (1) by using laser light (5) for forming at least one welding joint (7) within the contact region (CR),
wherein laser pulses are used for forming the at least one welding joint (7) and wherein the contact region (CR) includes nickel.

## Description

The present invention concerns a method for connecting a flexible printed circuit to a busbar and an arrangement of a busbar and a metal sheet realized by such a method.

Laminated busbars typically comprise conductive layers of fabricated copper separated by thin dielectric materials, laminated into a unified structure. For example, busbars can be used for collecting and transferring electrical power from a group of capacitors, connected to such a busbar and forming a battery package. Typically, such busbars are used in vehicles, driven by electrical motors. In order to use the battery package for signal control, flexible printed circuits (FPC) are connected to the busbar, for instance. Thus, it is possible, to establish a communication between the battery package, including the busbar, and a battery management system. Thereby, flexible printed circuits typically comprise a thin conductive path/track.

In general, rivet pins are used for realizing the electrical conductive connection between the busbar and the flexible printed circuit having the metal sheet. Further, it is known, for example from US 2018 0 335 060 A1, to use laser welding for realizing the connection between the flexible printed circuit and the busbar, wherein a welding line is realized by a continuous irradiation with a laser light from a fibre laser, while moving the laser light along a welding schedule line.

Considering the above, it is an object of the present invention to provide a method for connecting a flexible printed circuit to a busbar in an alternative and preferably improved manner compared to the state of the art.

This object is achieved by a method for connecting a flexible printed circuit to a busbar according to claim 1 and an arrangement of a busbar and a metal sheet according to claim 15. Preferred embodiments are incorporated in the dependent claims, the description and the figures.

According to a first aspect of the present invention, a method for connecting a flexible printed circuit to a busbar, is provided, comprising
- providing a metal sheet having a thickness between 0.1 mm and 0.5 mm, preferably between 0.13 mm and 0.3 mm and more preferably between 0.15 mm and 0.25 mm, wherein the metal sheet is connected to the flexible printed circuit, and providing the busbar,
- arranging the metal sheet at least partially on the busbar for forming a contact region,
- welding the metal sheet to the busbar by using laser light for forming at least one welding joint within the contact region,
wherein laser pulses are used for forming the at least one welding joint and wherein the contact region includes nickel.

In contrast to the state of the art, it is provided according to the present invention to realize the welding joints by laser pulses and to use nickel in the contact region. It turned out that by using laser pulses a sufficient resistance and a strong mechanical connection between the metal sheet and the busbar can be established. Thereby the metal sheet represents an adapter between the busbar and the flexible printed circuit. Especially, it turned out that a reliable connection can be realized for metal sheets by using laser pulses, in particular without damaging the metal sheet and the flexible printed circuit. Moreover, the connection is improved with respect to its adherence, when the contact region, i. e. the region, in which the laser welding will be realized, comprises nickel. Further, it turned out to be of advantage, when the metal sheet has a thickness between 0.1 mm and 0.5 mm, preferably between 0.13 mm and 0.3 mm and more preferably between 0.15 mm and 0.25 mm. Those thicknesses provides a flat metal sheet. In contrast to a flat metal sheet a non-flat metal sheet might not be flat enough to eliminate a gap between busbar and the metal sheet. However, those gaps can cause a flash or burn out in the welding process. As a consequence, it turned out that the probability for damaging the flexible printed circuit and/or the metal sheet decreases, when a contact region comprising nickel and a metal sheet of the specified thickness is provided for the laser welding mechanism. Thus, the metal sheet, preferably having a nickel coating or being formed by nickel, represents an optimized adapter for realizing a reliable and durable connection between the busbar and a flexible printed circuit board. Preferably, the metal sheet is arranged between the busbar and the flexible printed circuit board. In particular, the flexible printed circuit comprises a conductive path, being formed by a conductive wire or further metal sheet. Further, the conductive path of the FPC has an extension being significantly thinner than the thickness of the metal sheet, forming the adapter between the conductive path of the FPC and the busbar. Preferably, the extension or thickness of the conductive path is smaller than 0.5 mm, more preferably smaller than 0.2 mm and most preferably smaller than 0.1 mm. For example, a ratio of a thickness of the conductive path of the FPC to a thickness of the metal sheet is smaller than 0.2, preferably smaller than 0.1 and most preferably smaller than 0.05.

Especially, it turned out that a peeling force of more than 110 N is necessary to remove the metal sheet from the busbar after laser welding mechanism, when the contact region comprises Nickel, in particular when the metal sheet is made from Nickel (the force is related to the connection without additional components such as glues or coatings). Furthermore, it turned out that an electrically resistance of 0.5 to 5 mOhm is created by the welding seam. As a consequence, it is possible to create a resistance being required and favourable for the connection between the busbar and the FPC.

In particular, it is provided that the metal sheet comprises a nickel plate and/or is coated with nickel. For example, the nickel plate, such as a nickel pad, is formed by a metal sheet comprising at least nickel of 50 weigth -%, preferably at least 70 weight-% and most preferably at least 80 weight-%. Alternatively, another metal sheet such as a copper sheet is covered by nickel, for example by an electrochemical method, a plating method or by a sputtering process. Alternatively, it is also conceivable that the busbar is at least partially covered with nickel in a region forming the contact region after laser welding. Furthermore, it turned out that a laser welding seam can be produced by reduced power, but the realized laser welding seam has an improved peel/pull strength in case of using Nickel in the contact region.

Preferably, the busbar is a flat product extending in a main extension plane. The term flat in context of busbar means that a thickness of the busbar, measured in a direction perpendicular to the main extension plane, is at least 10 times, preferably at least 15 times, smaller than the extensions across the busbar in a plane parallel to the main extension plane. For instance, the busbar is laminated and/or covered with an insulation layer and/or a nickel layer for avoiding corrosion. It is provided according to an embodiment of the present invention that the busbar is made from a bare metal, without any further coating or covering. Further, the busbar is unstructured, i. e. the busbar includes no conductive paths in a common plane that are isolated from each other. Contrary, the metal sheet and the flexible printed circuit, being connected to the busbar, particularly represents at least a part of a conductive or signal path, for example for transferring a signal to a control unit, such as a battery management system. In particular, the contact region is at a top and/or bottom side of the busbar. Preferably, the contact region is localized at a terminal or part, being formed as a metal strip extending from a circumference of the busbar, preferably along a direction being parallel to the main extension plane. In another preferred embodiment it is provided that additionally or alternatively the contact region is on the edge of busbar, for example such that the FPC can connect with the terminals or ports of the busbar at said edge. Preferably, the busbar includes aluminum, copper, steel and/or nickel.

It is also provided according to an embodiment of the present invention that the busbar comprises at least one first conductive layer and/or at least one second conductive layer that are separated from each other by a further insulation layer, wherein the at least one first conductive layer, the at least one second conductive layer and the further insulation layer are stacked above each other along a stacking direction, being perpendicular to the main extension plane. Such busbars are particularly intended for collecting and transferring electrical power. For example, a plurality of capacitors is arranged on top of the busbar and the capacitors are connected to the busbar for distributing a total power collected from the plurality of capacitors. It is also provided in a preferred embodiment that the busbar is part of a battery package. In that case the busbar is used to connect battery cells in parallel or in series. The FPC here is used to collect the signal from these busbar, such as the electric potential and temperature of the welding area on busbar. Such busbars are intended for being used in electrical vehicles, for example. Preferably, the at least one first conductive layer and/or the at least second conductive layer is made from a metal, such as copper or aluminum. In particular, the thickness of the busbar, measured in a direction perpendicular to the main extension plane, is between 0.5 mm and 6 mm, more preferably between 0.5 mm and 3 mm, and most preferably between 0.5 mm and 1.5 mm. Especially, the thickness between 0.5 mm and 1.5 mm are favourably for busbars used in battery packs. Because the power transferred in vehicles is not very high as in other busbar applications, thin conductor can be used in such applications.

Furthermore, it is provided according to an embodiment of the present invention that a ratio of the thickness of the conductive path of the FPC to the thickness of the busbar is between 0.005 and 0.02, more preferably between 0.0075 and 0.015 and most preferably about 0.01. In other words: the conductive path of the FPC is very thin compared to the thickness of the busbar.

Particularly, the welding joints are realized as micro welding joints, i. e. as welding joints, having a comparable small cross section.

It is possible to use the connection between the flexibly printed circuit and the busbar in a battery package for signal control, in order to communicate with a battery management system. Thereby, it is provided according to an embodiment of the present invention that the flexible printed circuit only comprises the conductive path or conductive film is at least partially mounted onto or integrated into a flexible plastic substrate, formed for example by a polyimide, such as Kapton, or polyester film. Another advantage of connecting a flexible metal sheet, in particular as part of the flexibly printed circuit, to a busbar is that this possibly to bend the metal sheet and/or the flexible printed circuit, for example in order to compensate different heights of the busbar on one hand and a further course of the flexible printed circuit outside the region of the busbar on the other hand. It is also conceivable that two separated parts of the FPC are connected via the busbar by just connecting these two parts to the contact region. Preferably an additional tape or glue is used to protect the welding area and/or contact region and enhance the mechanical strength of the welding area and/or contact area.

According to a preferred embodiment it is provided that the metal sheet is soldered to at least a part of a flexible printed circuit in a soldering section, preferably in a section of the metal sheet including a recess or hole, such as a slot. In other words: the metal sheet is connected to the busbar by laser welding on the one hand and to the conductive path of the FPC on the other hand by soldering. Preferably, one end of the metal sheet is connected to the busbar, while another end of the metal sheet is connected to the FPC. It is also conceivable that the metal sheet is part of the FPC. Especially, a soldering section is formed between the conductive path of the FPC and the metal sheet and the contact region (including the laser weld) is formed between the busbar and the metal sheet. The recess or hole, especially the slot, is preferably arranged in a last third, preferably in a last quarter of the metal sheet facing the conductive path of the FPC.

In particular, a soldering section between the metal sheet and the flexible printed circuit is covered by a coating. For example the metal sheet is covered with a plastic.

Preferably, the coating is part of the flexible plastic substrate, formed for example by a polyimide and/or a white, coloured or transparent conductive polyester film, which extends across the soldering section between the flexible printed circuit and the busbar. For example, the soldering section is embedded into a coating for protecting the soldering connection between the conductive path and the metal sheet. The coating includes plastic, for example thermoplastic, a polyimide and/or transparent material. Especially, the coating completely surrounds both the metal sheet and the conductive path, in particular the end region of the conductive path, the end region being connected to the metal sheet.

Preferably, it is provided according to an embodiment of the present invention that the laser pulses have a pulse duration between 0.1 ns and 800 ns, preferably between 20 ns and 500 ns, preferably between 20 ns and 240 ns.

In particular, the metal sheet has a rectangular shape, for example having a first width between 4 and 10 mm and a second width between 5 and 15 width, the second width being larger than the first width. Especially, the metal sheet is connected to a flexible portion of conductive path of the FPC. For example, the metal sheet is connected to a strip like section of the FPC. Preferably a ratio of the welding area to a size of the metal sheet in a plane being parallel to the main extension plane is about 0,7 to 0,98, preferably between 0,8 and 0,98 and most preferably between 0,85 and 0,95.

Furthermore, it is provided that the contact region comprises a plurality of welding joints, wherein the welding joints are spatially separated from each other. By increasing the number of welding joints, it is advantageously possible to strengthen the mechanical connection between the metal sheet and the busbar. For example, the number of welding joints lies between 2 and 10, more preferably between 2 and 8, or between 3 and 7. Therefore, by increasing the number of welding joints, the total strength of the connection can be improved. Limiting the number has a positive effect on the time efficiency for realizing the connection. In particular, it turned out that realizing 3 to 7 welding joints guarantees a sufficient connection strength for most of potential applications and allows a fast production. Preferably, it is provided that several laser beams, formed each by laser pulses, are simultaneously directed on the contact region for accelerating the production of a group of welding joints.

In a preferred embodiment, it is provided that the plurality of welding joints is grouped, wherein, for example, a two-dimensional pattern is realised by the plurality of welding joints. It is possible to arrange the welding joints of the plurality of the welding joints such that the welding joints are optimized to the loads to the connection to be expected, for example depending on the direction of the expected forces that act on the connection between the busbar and the metal sheet or depending on the geometric form of the contact region.

In another embodiment, it is provided that prior to welding the metal sheet to the busbar, at least the contact region of the metal sheet is fixed to the busbar for forming a gap-free arrangement in the contact region. By guaranteeing a gap-free arrangement of the contact region between the busbar and the metal sheet, a success rate for establishing a strong mechanical connection between the busbar and the metal sheet can be advantageously increased. For example, the busbar and the metal sheet are fixed to each other by a clamp element, which tightens the metal sheet to the busbar, at least in the contact region. It is also conceivable that a frame-like construction presses the metal sheet to the busbar and fixates them together. Preferably, it is provided that a systematic control of the fixating state before the welding process is performed in order to avoid a faulty connection between the busbar and the metal sheet. Thus, a number of insufficient connections can be reduced.

According to a preferred embodiment, it is provided that prior to welding, a surface treatment is carried out on at least one part of the busbar. In particular, the section intended for providing the contact region is surface-treated prior to welding. For example, the surface of the busbar is cleaned for increasing the success rate for establishing the adhesive connection between the busbar and the metal sheet.

According to a preferred embodiment, it is provided that a ratio of the spot size of the welding joint to the size of the contact region is smaller than 0.2, more preferably smaller than 0.1, and most preferred smaller than 0.05. It turned out that even with such small welding joints it is possible to realise a sufficiently strong mechanical connection, which can be used as connection between the metal sheet and the busbar in practice. In particular, the small welding joints realise welding joints that are distributed over the contact region. Preferably, the welding joints are homogeneously distributed over the contact region. It is also conceivable that the welding joints are distributed statistically across the contact region.

In another embodiment, it is provided that the spot size of the welding joins is between 0.01 mm² and 5 mm², preferably between 0.1 mm² and 1 mm², and more preferably between 0.2 mm² and 0.7 mm². Preferably, the size of the contact region is between 1 mm² and 80 mm², more preferably between 5 mm² and 50 mm², and most preferably between 10 mm² and 25 mm².

In another preferred embodiment, it is provided that the welding joints in the group of welding joints are arranged at least partially in a row. Thus, the several welding joints can easily be realised in the production, for example by a lateral shift of a laser source and repeating the treatment with the laser pulses.

In particular, it is provided that the busbar is coated and/or plated with a metal layer, for example within and/or outside the contact region. For example, the whole busbar is covered with the metal layer. Preferably, it is provided that the busbar is coated, for instance with some nickel for corrosion avoidance. According to another embodiment, it is provided that the welding joints are equidistantly distributed, meaning that the distance between the welding joints - at least those along a line- is equal. It is also conceivable that the welding joints are distributed in-homogenous or even randomly. For example, the distance between the welding joints is not equidistantly distributed. This can be achieved by pre-setting a different welding program. That means a welding device having a corresponding laser source is included in an automatic welding system, which can load different welding program and realize automatic mass production. Thus, a homogeneous connection between the metal sheet and the busbar can be established, in order to provide a reliable connection strength.

According to a preferred embodiment, it is provided that the metal sheet outside the connection region extends slanted relative to the outer surface of the busbar, at least in the finished state of an arrangement including the busbar and the metal sheet. Thus, it is possible in an advantageous manner to adapt the orientation and/or position of the metal sheet depending on the application, i.e. allowing a transfer of the control signal from the busbar to another level in the arrangement, including the busbar and the metal sheet.

Preferably, it is provided that a cross-section of the welding joint is rectangularly, elliptically, triangularly and/or circularly shaped. By choosing or adapting the geometric form of the welding joint, it is further possible to adapt the mechanical strength of the connection between the busbar and the metal sheet. The circularly and elliptically shaped cross-sections can easily be realised by using laser pulses without requiring additional equipment, such as lenses or other beam forming equipment, which realise the special form of the laser spots used for welding the joints.

Another aspect of the present invention is an arrangement of a busbar and a metal sheet, in particular realised by a method according to the present invention, wherein the metal sheet is connected to the bus bar by welding joints, realized by laser pulses, being spatially separated from each other. All features and benefits described above for the method for realising the connection between the metal sheet and the busbar apply analogously to the arrangement, and vice versa.

Wherever not already described explicitly, individual embodiments or their individual aspects and features can be combined or exchanged with one another without limiting or widening the scope of the described invention, whenever such a combination or exchange is meaningful and in the sense of this invention. Advantages which are described with respect to one embodiment of the present invention are, wherever applicable, also advantageous of other embodiments of the present invention.

In the drawings:
- Fig. 1: schematically shows a method for connecting a metal sheet at least partially to a busbar,
- Fig. 2: an arrangement between a metal sheet and a busbar according to a first preferred embodiment,
- Fig. 3: an arrangement between a metal sheet and a busbar according to a second preferred embodiment,
- Fig. 4: an arrangement between a metal sheet and a busbar according to a third preferred embodiment and
- Fig. 5: an arrangement between a FPC and the busbar according to a fourth preferred embodiment.

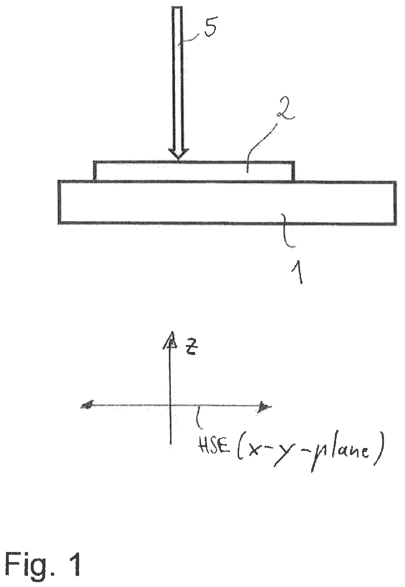

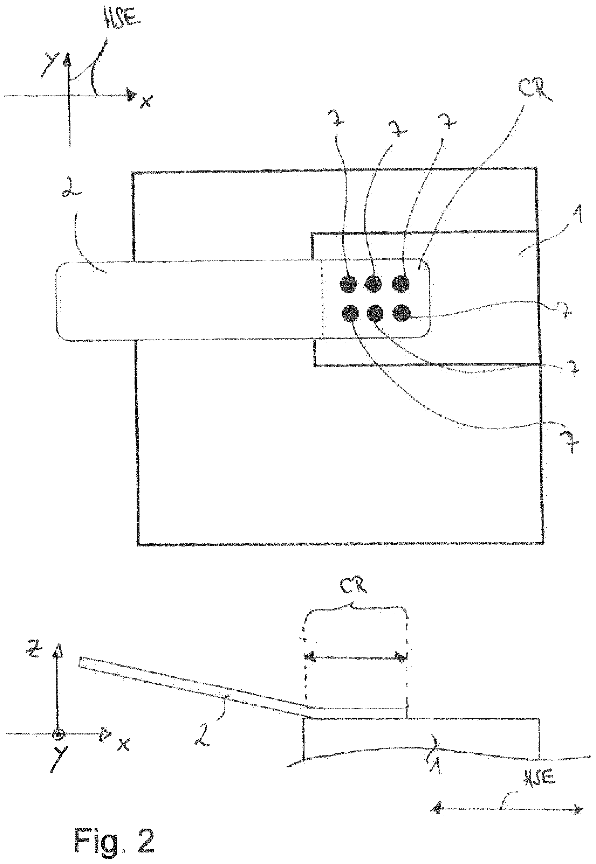

In **Figure 1**, a busbar 1 according to a first preferred embodiment of the present invention is schematically illustrated, namely in a cross-sectional side view (Figure 2). Such busbars 1 are intended for collecting and distributing electrical power of an arrangement of electric components, in particular for a plurality of capacitors (not shown), which are arranged on top of the busbar 1. More preferably, the busbar 1 is part of a battery package. In that case the busbar 1 is used to connect battery cells in parallel or in series. The busbar 1 extending in a main extending plane HSE, along an x-y-plane of a cartesian coordinate system, preferably forms a carrier for the electrical components (not shown) that are directly arranged on the busbar 1. Preferably, a first conductive layer of the busbar 1 is covered by an isolation layer, which allows arranging the capacitors directly on the first conductive layer.

Especially, the busbar 1 comprises a first conductive layer extending in the main extending plane HSE and has a port 9, in particular extending in a direction parallel to the main extending plane HSE from an outer periphery of the first conductive layer, for representing a common pole of the busbar 1 that collects the contributions of several first kind of poles that are each assigned to one capacitor of the several capacitors. Besides the first conductive layer, preferably a second conductive layer is provided, wherein the second conductive layer extends parallel to the first conductive layer. The busbar 1, in particular the first conductive layer and/or the second layer, form a flat or laminated product, i. e. the extension of the busbar 1 in the main extending plane HSE is several times larger than the thickness of the busbar 1 measured in a direction z perpendicular to the main extending plane HSE. Especially, the busbar 1 has a thickness measured in a direction z perpendicular to the main extension plane HSE between 0.5 mm and 6 mm, more preferably between 3 mm and 6 mm and most preferably between 4.5 and 5.5 mm. For busbars 1 used in battery packages it is preferably provided that the thickness measured in a direction z perpendicular to the main extension plane HSE is between 0.5 mm and 3 mm, and most preferably between 0.5 mm and 1.5 mm. In particular, the material of the first conductive layer and the second conductive layer are configured such that the busbar 1, at least parts of the busbar 1, can be deformed without affecting the functionality of the first and second conductive layer. Thus, the busbar 1 can easily adapted to the space to which the busbar 1 or the assembly including the busbar 1 should be incorporated to, for example by bending a part of the busbar 1. Further, the second conductive layer comprises at is outer periphery another port for representing a common pole of the busbar 1 that collects the contributions of a second kind of poles that are each assigning to one of the several capacitors. Those busbars 1 are used for example in vehicles driven by electrical motors.

Further, it is known to connect a flexible printed circuit (FPC) to the busbar 1 for signal control of a system including the capacitors and the busbar 1. The FPC includes conductive paths / tracks being for example used for signal control and having a thickness of less than 300 µm, preferably a thickness between 30 µm and 80 µm. Consequently, the ratio of the thickness of the conductive path 2 to the thickness of the busbar 1 is between 0.005 and 0.02, more preferably between 0.0075 and 0.15, and most preferred about 0.01. The FPC is for example used to collect the signal from these busbar 1, such as the electric potential and temperature of the welding area on busbar 1. In other words, the thickness of the busbar 1 is several times larger than the thickness of the conductive paths / tracks of the FPC. In order to realise a connection between the busbar 1 and the FPC in a time-efficient manner, a metal sheet is provided as adapter between the busbar 1 and the FPC. The metal sheet 2 is connected to the busbar via a welding joint 7 being realised by utilisation of laser light 5.

As a consequence of using such laser light 5, material between the metal sheet 2 and the busbar 1 is melted, and an adhesive connection between the metal sheet 2 and the busbar 1 is formed. It turned out that a connection of comparably low resistance, i. e. a few mOhm, is realised. Furthermore, another finding is that laser pulses can be used for realising a mechanically strong connection between the busbar 1 and the metal sheet 2. By using the laser pulses, it is therefore advantageously possibly to achieve a desired resistance and mechanical strength for the connection between the metal sheet 2 and the busbar 1 in a time-efficient way. In particular, it is provided to realise a micro welding joint 7 by using the laser light 5. It turned out that the use of laser pulses allows the realisation of the welding joints 7, without any damage to the metal sheet 2 connected to the busbar 1.

Furthermore, it is provided that the laser welding seam is realized in a contact region, the contact region, including Nickel. For example, the metal sheet 2 is made from Nickel and as a consequence, provides Nickel at the contact region CR between the busbar 1 and the metal sheet 2.

In **Figure 2****,** a connection between a busbar 1 and a metal sheet 2 according to a first preferred embodiment is shown. In the upper part of figure 2, a top view on a section including the connection between busbar 1 and the metal sheet 2 is illustrated. In the lower part of figure 2 a side view is shown, illustrating the connection between the busbar 1 and the metal sheet 2. In particular, it is provided that the busbar 1 extends along a main extension plane HSE, and the metal sheet 2 is arranged between the busbar 1 and the flexible printed circuit FPC. The metal sheet 2 is at least partially arranged on top of the busbar 1 in such a way that a contact region CR is established between the busbar 1 and the metal sheet 2. Specifically, the contact region CR is defined by the section of the busbar 1 and the metal sheet 2 that overlap with each other in a direction perpendicular to the main extension plane HSE, wherein the metal sheet 2 and the busbar 1 contact along the total area of the contact region CR. Furthermore, in Figure 2 it is shown that the metal sheet 2 is formed outside the contact region CR in such a manner that the metal sheet 2 extends slanted to the main extension plane HSE. This allows a transfer of the control signal 2 on a level different to that of the busbar 1.

Moreover, it is preferably provided that the connection between the busbar 1 and the metal sheet 2 is realised by a plurality of welding joints 7. Especially, the welding joints 7 are grouped and/or represented by micro welding joints 7, i. e. the cross-section of the welding joints 7 is comparably small. As it turned out, it is even possible to establish a mechanically strong connection between the metal sheet 2 and the busbar 1 by use of such small welding joints. For example, the cross-section area of the welding joints 7 is about 0.5 mm².

Preferably, the metal sheet 2 in the example shown in figure 2 forms a adapter to a flexibly printed circuit FPC, the metal sheet 2 being welded on a bare busbar 1 made from aluminium, and having a thickness of 0.5 mm. Especially, the welding joints 7 are realised by laser pulses, having a duration of 6 ps, wherein a total irradiation duration for forming these welding joints 7 takes about 2 s. Furthermore, the group of welding joints 7 forms a pattern, especially a two-dimensional pattern. In the example of Figure 2, the pattern comprises of welding joints 2 being equidistantly separated from each other.

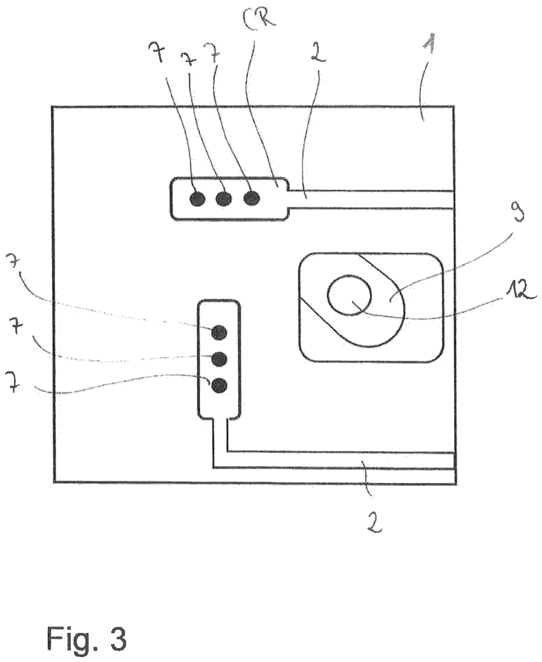

In **Figure 3**, a connection between a busbar 1 and a metal sheet 2 according to a second preferred embodiment is shown. The section shown or illustrated in Figure 3 includes a port 9 for the busbar 1, wherein the port 9 has an opening 12 for realising a connection to the busbar 1 for supplying electrical power to the user. The embodiment shown in Figure 3 differs from the embodiment of Figure 2 e.g. by the geometrical form of the contact region CR. In figure 3 two different and separated contact regions CR are shown, and the metal sheet 2 also comprises an electrically conductive path or signal path outside of the contact region CR. Each of the contact regions CR have three welding joints 7 that are arranged in a row.

Preferably, a flexibly printed circuit FPC is connected to an aluminium busbar 1 of 1 mm thickness, via the metal sheet 2 forming the adapter. By using laser pulses, having a pulse duration of 3 ps, a welding joint 7 having a cross-section of about 0.5 mm² can be realised. In particular, the total duration of illuminating the contact region CR at least partially takes about one second.

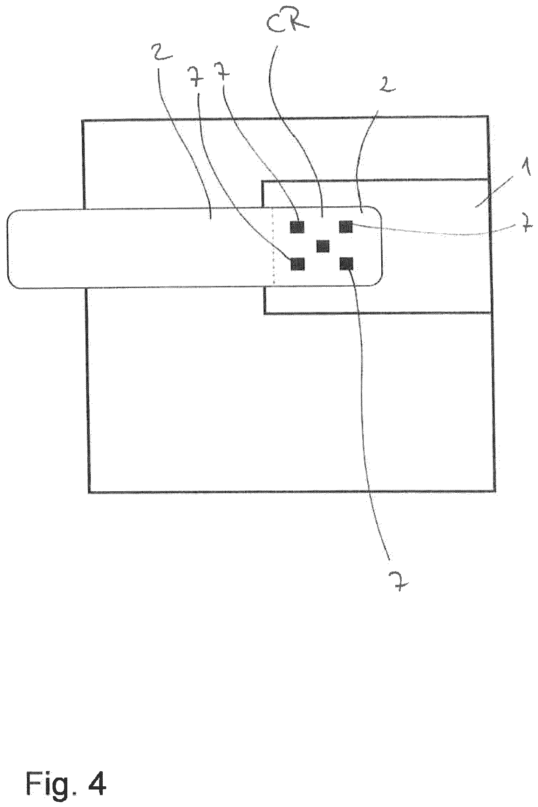

In **Figure 4****,** a connection between a busbar 1 and a metal sheet 2, according to a third preferred embodiment is shown. The embodiment shown in Figure 4 mainly corresponds to the embodiment shown in Figure 2, and is only distinguished from the embodiment of Figure 2 by its form, meaning the geometrical form of the cross-sectional area of the welding joints 7, whereas the cross-section areas in Figure 2 have a circular form, the welding joints 7 shown in figure 2 are of a rectangular shape.

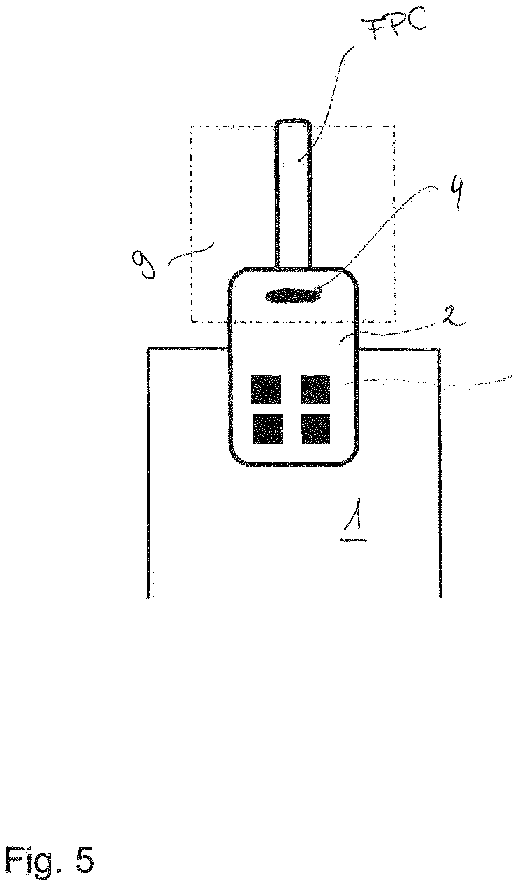

In **Figure 5****,** an arrangement between a flexible printed circuit FPC and the busbar 1 according to a fourth preferred embodiment is illustrated. Compared to the previous illustrations and shown embodiments, figure 5 also includes the flexible printed circuit FPC, being connected to the metal sheet 2. Especially, the connection between the metal sheet 2 and a conductive path of the flexible printed circuit FPC is realized by a soldering. In other words: There is a material connection realized between the conductive path of the flexible printed circuit FPC and the metal sheet 2 being, in turn, connected to the busbar 1 via the laser welding mechanism. Preferably, the metal sheet 2 includes a hole 4 or a recess, in particular a slot, for receiving a portion of the soldering material and/or or the conductive path/track of the FPC in a soldering area of the metal sheet 2, i. e. in an soldering section between the metal sheet 2 and the FPC.

In particular, it is provided that the metal sheet 2 is connected to the busbar 1, for example to a terminal or port of the busbar 1 via the welding mechanism. The metal sheet 2 has a thickness being between 0.1 mm and 0.5 mm, preferably between 0.15 and 0.25 mm. As a consequence, the metal sheet 2 is thicker than the thickness of the conductive path, especially measured in the same direction being perpendicular to the main extension plain HSE. For protecting and further reinforce the connection between the conductive path and the metal sheet 2, the interface/soldering section being formed for example by the soldering is embedded into a covering or coating. Especially, the soldering section is covered or coated by a plastic material, which protects the soldering section. Preferably, this coating extends over large parts of the flexible printed circuit FPC.

Furthermore, it is provided that the metal sheet 2 forms an adaptor for creating the connection between the flexible printed circuit FPC and the busbar 1. For improving the connection between the busbar 1 and the metal sheet 2, it turned out that using nickel in the contact region CR is of advantage. Especially, it turned out that a force, being necessary for peeling off the metal sheet 2 from the busbar, increases when there is nickel included in the contact region CR, the contact region CR, being established between the metal sheet 2 and the busbar 1, especially due to the laser welding process. For example, the metal sheet 2 is formed by some metal material being covered by nickel coating and/or is formed by a nickel pad. Alternatively, it is also considerable that in the planned contact region CR, the busbar 1 comprises at least partially a nickel coating, being for example sputtered onto the outside of the busbar 1.

### Reference signs

- 1: busbar
- 2: metal sheet
- 4: hole
- 5: laser light
- 7: welding joint
- 9: port
- 12: hole
- FPC: flexible printed circuit
- CR: contact region
- HSE: main extension plane
- x, y, z: coordinate system

## Claims

1. A method for connecting a flexible printed circuit (FPC) to a busbar (1), comprising
- providing a metal sheet (2) having a thickness between 0.1 mm and 0.5 mm, preferably between 0.13 m and 0.3 mm and more preferably between 0,15 mm and 0.25 mm, wherein the metal sheet (2) is connected to the flexible printed circuit (FPC), and providing the busbar (1),
- arranging the metal sheet (2) at least partially on the busbar (1) for forming a contact region (CR),
- welding the metal sheet (2) to the busbar (1) by using laser light (5) for forming at least one welding joint (7) within the contact region (CR),
wherein laser pulses are used for forming the at least one welding joint (7) and wherein the contact region (CR) includes nickel.

2. The method according to claim 1, wherein the metal sheet (2) is soldered to a flexible printed circuit (FPC) in a soldering section, preferably in a soldering section of the metal sheet (2) including a recess or hole, such as a slot.

3. The method according to one of the preceding claims, wherein a ratio of a thickness of the conductive path of the flexible printed circuit (FPC) to a thickness of the metal sheet (2) is smaller than 0.2, preferably smaller than 0.1 and most preferably smaller than 0.05.

4. The method according to one of the preceding claims, wherein a plurality of welding joints (7) is realized within the contact region (CR), wherein the welding joints (7) are preferably spatially separated from each other.

5. The method according to one of the preceding claims, wherein an soldering section between the metal sheet (2) and the flexible printed circuit (FPC) is covered by a coating (9), for example in form of a covering plastic, especially including polyimide.

6. The method according to one of the preceding claims, wherein prior to welding the metal sheet (2) to the busbar (1), at least the contact region (CR) of the metal sheet (2) is fixed to the busbar (1) for forming a gap-free arrangement in the contact region (CR).

7. The method according to one of the preceding claims, wherein the metal sheet (2) comprises a nickel plate, in particular a pure nickel plate, and/or is coated with nickel.

8. The method according to one of the preceding claims, wherein a ratio of a spot size of the welding joint (7) to a size of the contact region (CR) is smaller than 0.2, more preferably smaller than 0.1 and more preferably smaller than 0.05.

9. The method according to one of the preceding claims, wherein the spot size of the welding joint (7) is between 0.01 mm² and 5 mm², preferably between 0.1 mm² and 1 mm² and more preferably between 0.2 mm² and 0.7 mm².

10. The method according to one of the preceding claims, wherein the size of the contact region (CR) is between 1 mm² and 80 mm², preferably between 5 mm² and 50 mm² and more preferably between 10 mm² and 25 mm².

11. The method according to one of the claims 4 to 10, wherein the welding joints (7) of the group of welding joints (7) are at least partially arranged in a row.

12. The method according to one of the preceding claims, wherein the busbar (1) is coated and/or plated with a metal layer, for example within and/or outside the contact region (CR).

13. The method according to one of the preceding claims, wherein the flexible printed circuit (FPC) and/or the metal sheet (2) outside the connection region (CR) extends slanted or curved relative to an outer surface of the busbar (1).

14. The method according to one of the preceding claims, wherein a cross section of the welding joint is at least partially rectangularly, elliptically, triangularly, and/or circularly shaped.

15. An arrangement of a busbar (1) and a metal sheet (2), in particular realized by a method according to one of the preceding claims, wherein the metal sheet (2) is connected to the busbar (1) by at least one welding joint (7), realized by laser pulses, preferably by welding joints, being spatially separated from each other.
